# EUROPÄISCHE PATENTSCHRIFT

(11) **EP 1 099 307 B1**
(45) Veröffentlichungstag und Bekanntmachung des Hinweises auf die Patenterteilung: **10.09.2003**
(21) Anmeldenummer: 99936545.5
(22) Anmeldetag: 15.07.1999
(51) Int. Cl.: H03K 17/945, H03K 17/94

(54) **INTEGRIERTE SCHALTUNGSANORDNUNG MIT EINEM SENSORELEMENT**
INTEGRATED CIRCUIT WITH A SENSOR ELEMENT
CIRCUIT INTEGRE DOTE D'UN ELEMENT CAPTEUR

(30) Priorität: 16.07.1998 DE 19831978
(43) Veröffentlichungstag der Anmeldung: 16.05.2001
(73) Patentinhaber: Micronas GmbH, 79108 Freiburg (DE)
(72) Erfinder: BLOSSFELD, Lothar, D-79874 Breitnau (DE); JANKE, Ralf, D-79194 Gundelfingen (DE)
(74) Vertreter: Patentanwälte Westphal, Mussgnug & Partner
(86) Internationale Anmeldenummer: EP9905052
(87) Internationale Veröffentlichungsnummer: WO00004640

(56) Entgegenhaltungen:
- EP-A- 0 458 513
- EP-A- 0 844 464
- DE-A- 4 306 950
- DE-A- 4 438 507
- US-A- 5 276 389
- HOGENBIRK ET AL.: "An integrated smart sensor for flow and temperature with I2C bus interface: FTS2", IEEE INTERNATIONAL SYMPOSIUM ON CIRCUITS AND SYSTEMS, SEATTLE, 30. April 1995, Band 3, Nr. , Seiten 2225 - 2228

## Beschreibung

Die Erfindung betrifft eine integrierte Schaltungsanordnung mit einem Sensorelement.

Es sind integrierte Schaltungsanordnungen mit Sensorelementen, z. B. mit Magnetsensoren bekannt, welche in einer Vielzahl von Anwendungen im Consumer- und Automotive-Bereich mechanische Schaltzustände erfassen. Bei diesen wird ein mechanischer Schaltzustand mittels eines veränderlichen Magnetfeldes, das aufgrund eines veränderlichen Abstandes zwischen Magnetfeldsensor und einem beweglichen Magneten die veränderte Position darstellt, bestimmt. Die physikalische Größe der magnetischen Feldstärke wird damit als Maß zur Festlegung des Schaltzustandes verwendet. Nähert sich der Magnet dem Wandler, der die magnetische Feldstärke in ein analoges elektrisches Signal wandelt, so wird bei Unterschreiten eines bestimmten Abstandes A1 der Schaltzustand "eingeschaltet" am Ausgang der Sensorschaltung dargestellt. Wird ein weiterer Abstand A2 unterschritten, so wird das Ausgangssignal "ausgeschaltet" dargestellt. Damit wird deutlich, daß diese Sensorschaltung genau einen Schaltzustand entweder "eingeschaltet" oder "ausgeschaltet" darstellen kann. Sollen wesentlich differenziertere, vielfältigere Schaltzustände dargestellt werden, ist es notwendig, eine kaskadierende Anordnung aus derartigen Sensorschaltungen zu verwenden, was sehr aufwendige Gesamtschaltungen von großen Ausmaßen und Kosten erfordert. Zudem erweisen sich solche Gesamtschaltungen als in hohen Maß anfällig. Darüber hinaus erweisen sich derartige Gesamtschaltungen als stark EMV-gefährdet, was bei Anwendungen im Automotive-Bereich von großem Nachteil ist.

Die EP 0844 464 A1 beschreibt eine Sensorvorrichtung mit Mitteln zur Aufnahme eines Messwertes, der einen zu erfassenden physikalischen Zustand repräsentiert Die Vorrichtung umfasst eine Vielzahl von Anzeigeelementen, als Balkenanzeige ausgebildete, Anzeigeeinheit zur Anzeige des Messwertes und eine Schwellwertanzeigeeinheit, die eine Vielzahl von Azeigeelementen umfasst, zur Anzeige eines eingestellten Schwellwertes in Korrelation zu der Balkenanzeige. Die Vorrichtung umfasst weiterhin Bewertungsmittel zum Vergleichen des Messwertes mit dem Schwellwert und zur Ausgabe des Vergleichsergebnisses.

Hogenbisk et. al.: "AN INTEGRATED SMART SENSOR FOR FLOW AND TEMPERATURE WITH I²C BUS INTERFACE ": FTS2, IEEE INTERNATIONAL SYMPOSIUM ON CIRCUITS AND SYSTEMS, SEATTLE , 30. APRIL 1995, BAND 3, SEITEN 2225-2228 beschreibt einen Duchflusssensor wit zwei integrierten Temperatursensoren, wobei die sensoren jeweils eine I²C-Schnittstelle aufweisen, die Sensorsignale jeweils in ein serielles Ausgangssignal umsetzen.

Aufgabe der Erfindung ist es, eine integrierte Schaltungsanordnung mit einem Sensor darzustellen, die differenzierte Schaltzustände also mehr als nur den einen Schaltzustand "eingeschaltet" oder "ausgeschaltet" darstellen kann und die eine sichere Charakterisierung der einzelnen Schaltzustände ermöglicht.

Diese Aufgabe wird erfindungsgemäß durch eine Sensorschaltung mit den Merkmalen des Anspruchs 1 gelöst.

Vorteilhafte Weiterbildungen ergeben sich aus den Unteransprüchen.

Errindungsgemäß weist die Schaltungsanordnung, die mehr Schaltzustände als nur "eingeschaltet" oder "ausgeschaltet" darstellen kann, eine Steuereinheit zur Steuerung der Sensorschaltung und einen Eingang auf, dem ein analoges elektrisches Signal zugeführt wird, das einer analogen physikalischen Größe, wie Druck, Kraft, Beschleunigung, Magnetfeldstärke, elektromagnetische Feldstärke, Temperatur, Lichtstärke oder ähnlichem entspricht. Dieses elektrische Eingangssignal wird in einer Analyseeinheit oder Komparatoreinheit mit mehreren Schwellwerten verglichen, die zu Schwellwertepaare zusammengefasst sind, die beabstandeten Wertintervalle festlegen, wobei jedem Wertintervall ein bestimmter diskreter Schaltzustand zugeordnet ist und zwischen den einzelnen Wertintervallen eine Hysterese vorgesehen ist, wobei ein Ausgangssignal generiert wird, in dem die verschiedenen Schaltzustände codiert sind und das eine Reihe von verschiedenen Schaltzuständen, die über den einen Schaltzustand "eingeschaltet" oder "ausgeschaltet" hinausgehen, darstellen kann. Dieses Ausgangssignal wird von der Analyseeinheit oder Komparatoreinheit der Ausgangsstufe zugeführt und zur weiteren Verwendung an die Umgebung der Sensorschaltung zur Verfügung gestellt.

Damit gelingt es erfindungsgemäß mit einer einzigen Sensorschaltung, die eine einzige Steuereinheit, eine einzige Analyseeinheit, eine einzige Ausgangsstufe und einen Eingang aufweist, verschiedene differenzierte Schaltpositionen auf besonders einfache, platzsparende und sichere Weise darzustellen, was beispielsweise bei dem kontaktlosen Abgreifen der vielen Stellungen des Wischerhebels im Automobil mittels Hall-Sensoren und entsprechend nachgeschalteter, erfindungsgemäßer Sensorschaltung erfolgen kann. Die vielen verschiedenen Positionen des Wischerhebels wie zum Beispiel "aus", "ein langsam", "ein schnell", "ein sehr schnell" oder "Intervall-Betrieb" werden durch eine derartige Anordnung mit der erfindungsgemäßen Sensorschaltung in ein elektrisches Ausgangssignal umgesetzt, durch welches diese vielen Schaltzustände eindeutig diskret darstellbar sind. Erfindungsgemäß kann auf eine kaskadierende Anordnung mehrerer Sensorschaltungen wie beim Stand der Technik verzichtet werden, was mit einer erheblichen Reduktion der Kosten, des benötigten Platzes für die Schaltungen, des Schaltungsaufwandes und Verkabelungsaufwandes, mit einer deutlichen Verringerung der Anfälligkeit durch Bauteilreduktion sowie einer Verbesserung der EMV-Empfindlichkeit aufgrund der Reduktion der EMV-empfindlichen Komponenten wie auch eine Reduktion der EMV-generierenden Komponenten verbunden ist. Mithin erweist sich die erfindungsgemäße Sensoranordnung als bestens geeignet im Automotive-Bereich, wo gerade besondere Anforderungen an EMV-Verträglichkeit und platzsparende Anordnungen bestehen, eingesetzt zu werden.

Zudem erweist sich diese Sensorschaltung als sehr universelle Sensorschaltung, da sie mit den verschiedensten Wandlern zur Umwandlung der verschiedenen analogen physikalischen Größen in analoge elektrische Signale zusammenarbeiten kann. In diesem Fall muß allein das analoge elektrische Signal durch Verwendung eines entsprechenden Signalverstärkers in einen bestimmten Größenbereich verstärkt werden und dem Eingang zugeführt werden und gegebenenfalls die Schwellwerte angepaßt werden.

Der Wandler zur Wandlung der analogen physikalischen Größe in ein analoges elektrisches Eingangssignal ist mit dem einen Eingang verbunden und dadurch in die Sensorschaltung integriert. Dadurch wird es möglich, den Wandler bzw. Sensor optimal auf die restliche Sensorschaltung zu adaptieren und dadurch eine geschlossene und standardisierte Sensorschaltung zu schaffen, die vom Benutzer keine spezifische Anpassung mehr benöcigt, wodurch eine Vielzahl von Störungen einer solchen standardisierten Schaltung mit Wandler ausgeschlossen ist, insbesondere dann, wenn der Benutzer bei der Adaption des Ausgangssignals des Wandlers an die restliche Schaltung die Zusammenhänge mit den Schwellwerten nicht korrekt berücksichtigt. Dies führt regelmäßig zu erheblichen Problemen in der Eindeutigkeit des Ausgangssignals und damit in der Darstellung der Vielzahl der diskreten Schaltzustände. Weiterhin ist es nun möglich, die standardisierte Sensorschaltung mit Wandler insbesondere raum- und EMVoptimiert auszubilden, da die Wechselwirkungen des Wandlers und der restlichen Sensorschaltung bei deren Konstruktion Berücksichtigung finden können.

Die Sensorschaltung ist mit einer Ausgangsstufe mit einem einzigen Ausgang versehen. An diesem einen Ausgang wird die Vielzahl an diskreten Schaltzuständen beispielsweise durch das Puls-/Pausenverhältnis des Ausgangssignales oder durch ein digitales nicht notwendigerweise binär codiertes Signal oder durch ein analoges Signal, das eine der Vielzahl an Schaltzuständen entsprechende Anzahl an Signalstufen aufweist, dargestellt. Sollen beispielhaft fünf Schaltzustände dargestellt werden, so kann das Puls/Pausenverhältnis zwischen 5/1, 4/2, 3/3, 2/4 und 1/5 variieren. Neben diesen Beispielen sind auch weitere Darstellungsformen der Vielzahl an Schaltzuständen mit einem einzigen Ausgang vorscellbar. Die Ausbildung der Sensorschaltung mit einem einzigen Ausgang stellt eine in besonderem Maß kostenoptimierte Sensorschaltung dar, da nun nicht mehrere parallele Ausgänge zur Verfügung gestellt werden müssen.

Die Schwell-werte sind einstellbar ausgebildet, wodurch ein Adaptieren an die jeweiligen äußeren Gegebenheiten für die Bildung des Ausgangssignals in Abhängigkeit von dem elektrischen Eingangssignal ohne Neuschaffung einer entsprechenden Sensorschaltung möglich ist. Dadurch ist es möglich, eine Adaption vorzunehmen, die mögliche zeitliche Veränderungen wie Alterungseffekte in der Schaltungsanordnung insbesondere im der Schaltungsanordnung zugeordneten Wandler berücksichtigt. Auch können auf einfache Weise Fertigungstoleranzen oder Veränderungen aufgrund verschiedener Einsatzbedingungen, beispielsweise aufgrund von Temperatureffekten o.ä., auf einfache kostengünstige Weise berücksichtigt werden. Dadurch ist der Einsatzbereich der Sensorschaltung wesentlich erweitert, indem ihre Funktionalität weiter gesteigert wird, ohne daß aufwendige und kostenintensive äußere Beschaltungen zur Anpassung des Ausgangssignals oder des Eingangssignals erforderlich sind. Dadurch ist eine sehr einfache und sichere Sensorschaltung gegeben, die sich insbesondere durch eine sehr kostengünstige und flexible Ausbildung auszeichnet.

Eine besonders bevorzugte Ausbildungsform der Sensorschaltung zeigt die Möglichkeit, daß der Benutzer selbst die Schwellwerte festlegt. Dies kann in einem speziellen Lernmodus für die Sensorschaltung stattfinden, in dem die gewünschten Schaltbereiche der Sensorschaltung angefahren werden und die Analyseeinheit in Zusammenarbeit mit der Steuereinheit die notwendigen Parameter der Schwellwerte bestimmt und in einem entsprechenden Speicher, der insbesondere als nichtflüchtiger Speicher ausgebildet ist, abgelegt werden. Dadurch ist eine besonders flexible und sehr allgemein einsetzbare Sensorschaltung gegeben, die dem Benutzer einen sehr großen vielfältigen Einsatzbereich gewährt.

Die Schwellwerte sind zu Schwellwertepaaren zusammengefaßt, die ein Werteintervall festlegen, dem ein bestimmter, diskreter Schaltzustand zugeordnet ist. Eevorzugt sind diese Schwellwertepaare eng voneinander beabstandet, so daß der Zwischenbereich, dem nicht notwendigerweise ein bestimmter Schaltzustand zugeordnet ist, sehr eng gehalten ist, so daß die Sensorschaltung nahezu über den ganzen Meßbereich der analogen physikalischen Größe eindeutig definierte Schaltzustände generiert. Durch die Wahl von Schwellwertepaaren gelingt es auf einfache Weise, sehr sicher bestimmte Schaltzustände eindeutig zu charakterisieren und damit eine sehr sicher arbeitende Sensorschaltung auszubilden.

Die Sensorschaltung mit den Schwellwerte-paaren ist so ausgebildet, daß zwischen den einzelnen Schwellwertepaaren eine Hysterese vorgesehen ist. Dies stellt sicher, daß in dem vorzugsweise engen Bereich zwischen den einzelnen Schwellwertepaaren ein definierter Schaltzustand gegeben ist, der sich insbesondere dadurch auszeichnet, daß diese Sensorschaltung bei einem häufigen geringen Schwanken um einen Schwellwert nicht stets zu einem unerwünscht häufigen Hin- und Herschalten zwischen den einzelnen Schaltzuständen führt. Dadurch ist sichergestellt, daß das System bestimmte Schaltzustände sehr sicher und beharrlich annimmt.

Vorzugsweise ist die Sensorschaltung so ausgebildet, daß sie kurzfristige Änderungen des Eingangssignals ignoriert und diese nicht für eine Änderung des Schaltsignals berücksichtigt. Durch eine derartige Ausbildung werden kurzzeitige Störsignale, die in einer elektronischen Schaltung immer wieder vorkommen können, sei es aufgrund von elektromagnetischen Einstrahlungen von außen oder durch Schaltungsinterferenzen, zwar nicht verhindert jedoch werden ihre negativen Auswirkungen verhindert. Dies kann durch die Verwendung von integrierenden oder mittelnden Elementen am Eingang erreicht werden. Damit ist die besondere Störunempfindlichkeit der Sensorschaltung gegeben.

Die Sensorschaltung ist als integrierter Schaltkreis ausgebildet, was gerade im Hinblick auf die EMV-Verträglichkeit und die geringe Größe derartiger integrierter Schaltkreise eine besonders vorteilhafte Sensorschaltung zum Gegenstand hat. Insbesondere erweist sich eine Sensorschaltung mit einem integrierten Wandler in Form eines integrierten Schaltkreises als vollständige Sensorschaltung, die mit sehr wenigen Pins auskommt und dadurch auch sehr kostengünstig und wenig störanfällig ist. Darüber hinaus erweist sich eine derartig komplette Sensorschaltung als äußerst klein. Damit ist ein Einsatz insbesondere im Automobilbereich als prädestinierte Anwendung gegeben, da dort gerade enge räumliche Gegebenheiten und besondere Ansprüche an die EMV-Verträglichkeit vorliegen.

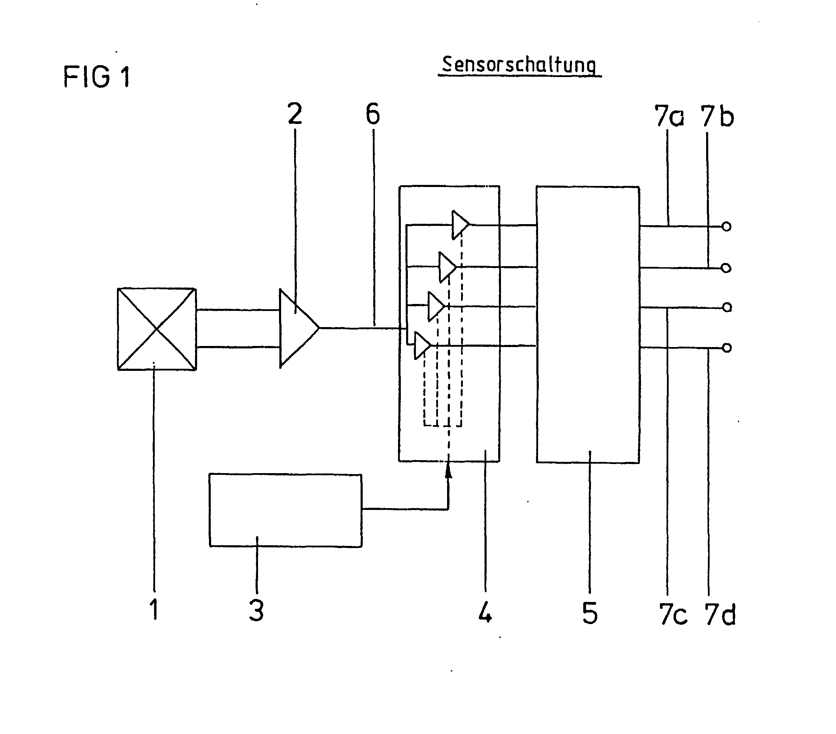

Eine Schaltungsanordnung mit einem Sensorelement ist in der Fig. 1 in Form eines Blockschaltbildes dargestellt und wird im folgenden näher beschrieben.

Die dargestellte Sensorschaltung zeigt einen Wandler 1, der eine analoge physikalische Größe beispielsweise eine Temperatur oder eine Magnetfeldstärke oder einen Druck in ein elektrisches Signal umwandelt und es einem Verstärker 2 zuführt, dessen verstärktes elektrisches Signal dem Eingang 6 der Analyseeinheit 4 zugeführt wird. Die Analyseeinheit 4 zeigt eine Komparatorenanordnung, deren Komparatorschwellen mittels einer Steuereinheit 3, die mit der Analyseeinheit 4 verbunden ist, eingestellt werden können. Die Parameter für die Schwellwerte der Komparatoren in der Analyseeinheit 4 sind in einem nicht dargestellten Speicher in der Steuereinheit 3 abgelegt und werden zur Steuerung der Komparatorschwellen verwendet.

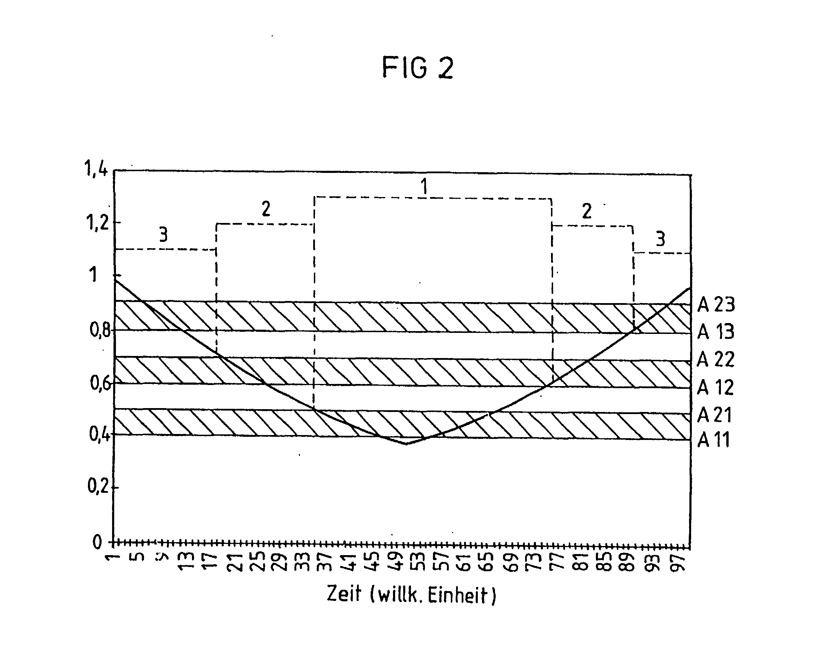

Das Eingangssignal am Eingang 6 wird den Komparatoren in der Analyseeinheit 4 zugeführt, welche je nach Verhältnis des Eingangssignals zu den jeweiligen Komparatorschwellen ein entsprechendes Ausgangssignal der Komparatoren generiert und dieses der Ausgangsstufe 5 zuführt. Diese überträgt die Signale der Analyseeinheit 4 in ein Ausgangssignal, das auf die vier Ausgänge 7a, 7b, 7c und 7d verteilt wird. Durch die verschiedenen Ausgänge 7a, 7b, 7c, 7d der Ausgangsstufe 5 ist es möglich, direkt vier verschiedenen an die Ausgänge 7a, 7b, 7c, 7d angeschlossene Geräte oder auch Gerätegruppen selektiv und unabhängig voneinander anzusteuern. Damit wird deutlich, daß abhängig vom Maß der einen analogen physikalischen Größe mehrere Geräte unabhängig voneinander durch die Sensorschaltung ohne aufwendige zusätzliche Decoderschaltungen ein- oder ausgeschaltet werden können.
Ein beispielhaftes Schaltverhalten ist in der Fig. 2 dargestellt. In Fig. 2 ist der zeitliche Verlauf einer analogen Meßgröße in einer willkürlichen Einheit als durchgezogene Linie dargestellt. Dabei sinkt diese analoge Meßgröße von dem Wert 1 auf den Tiefstand knapp unter 0,4 ab und steigt dann wiederum auf einen Wert von etwa 1 an. Es sind drei Paare von Schwellen A11, A21; A12, A22; A13 und A23 dargestellt, wobei gilt:
A11<A21<A12<A22<A13<A23.

Dem Schaltungsdiagramm ist der Verlauf des Ausgangssignals, welches als gestrichelte Linie dargestellt ist, zu entnehmen. Das Ausgangssignal zeigt drei verschiedene diskrete Schaltungszustände, den Schaltungszustand 1, 2 und 3.

Liegt die analoge Meßgröße innerhalb des Intervalls A11 bis A21, so zeigt das Diagramm den Schaltungszustand 1. Liegt die analoge Meßgröße im Schwellwerteintervall A12 und A22, so nimmt das Ausgangssignal den Schaltzustand 2 an. Liegt die analoge Meßgröße in Schwellwerteintervall A13 bis A23, so nimmt es den Schaltzustand 3 an.

Darüber hinaus zeigt das Diagramm, daß zwischen den durch die Schwellwertepaare gebildeten Schwellwerteintervallen eine Hysterese vorgesehen ist. Diese stellt sicher, daß bei einem Absinken der analogen Meßgröße von einem analogen Meßwert innerhalb des Intervalls A13 bis A23 unter die Grenze A13 der Meßzustand weiter beibehalten wird, bis die Obergrenze des nächsten Schwellwerteintervalls A12, A22 erreicht wird. Erst bei einem Abfall der analogen Meßgröße auf den Schwellwert A22 wird von dem Schaltzustand 3 auf den Schaltzustand 2 gewechselt. Entsprechendes gilt bei einem weiteren Abfallen bis auf den Schwellwert A21, wo dann vom Schaltungszustand 2 auf den Schaltungszustand 1 gewechselt wird. Entsprechendes gilt auch bei einem Anstieg der analogen Meßgröße, wobei hier der ursprüngliche Schaltzustand so lange beibehalten wird, bis die Untergrenze des nächsten Schwellwerteintervalls erreicht wird. Das bedeutet, daß bei einem Anstieg der analogen Meßgröße von einem Wert 0,4, das entspricht der Schwelle A11 über den Schwellwert A21 bis zum Erreichen des unteren Schwellwertes A12 der Schaltzustand 1 beibehalten wird, auch wenn das Schwellwerteintervall A11 bis A21, das dem eigentlichen Schaltzustand 1 entspricht, verlassen wurde. Mit Erreichen des Schwellwertes A12 wird der Schaltzustand 2 eingenommen und dieser bei einem weiteren Anstieg der analogen Meßgröße bis zum Erreichen des Schwellwertes A13 beibehalten. Danach findet ein Übergang des Schaltzustandes 2 zum Schaltzustand 3 statt.

Durch diese Ausbildung der Schwellwerte als drei Schwellwertepaare, die jeweils über einen Hysteresebereich miteinander verbunden sind, wird es ermöglicht, sehr sicher drei diskrete Schaltzustände in Abhängigkeit einer sich verändernden analogen Meßgröße darzustellen. Insbesondere ist durch die Ausgestaltung mit Hysteresebereichen sichergestellt, daß ein definiertes Schalten zwischen den einzelnen Schaltzuständen gegeben ist und dadurch ein unerwünschtes häufiges Umschalten bei Schwankungen um einen Schwellwert vermieden werden kann. Dies macht die Sensorschaltung zu einer besonders sicheren und gut zu handhabenden Schaltungsanordnung, welche eine Vielzahl von diskreten Schaltzuständen eindeutig darstellen kann.

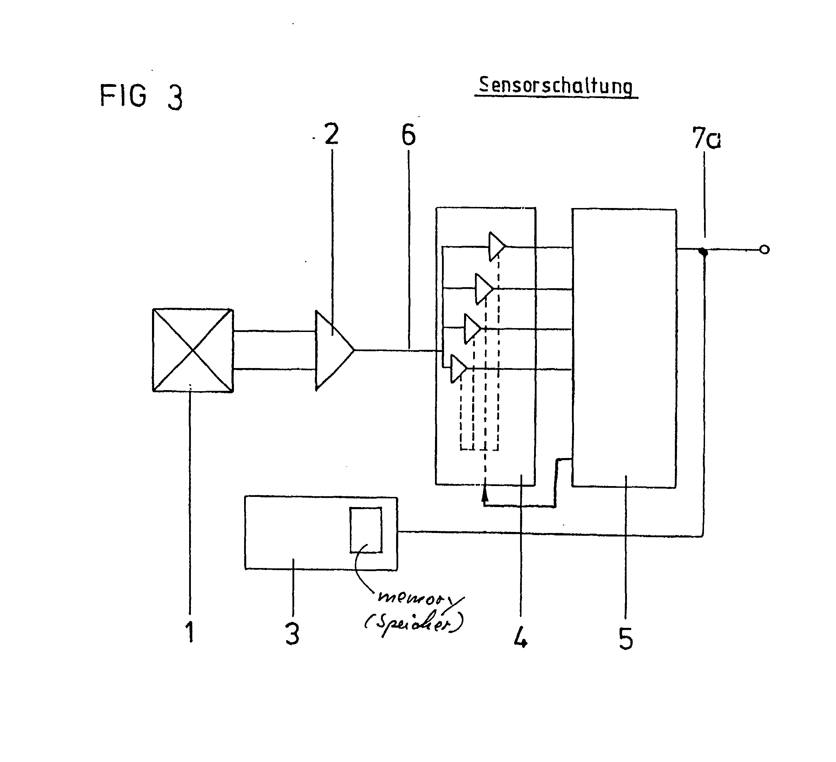

In Fig. 3 ist eine erfindungsgemaße Schaltungsanordnung gezeigt. Die Schaltung weist im Gegensatz zu der in Fig. 1 dargestellten eine einzige Ausgangsklemme 7a auf, an der die verschiedenen Schaltzustände des elektrischen Signals codiert abgreifbar sind. Diese eine Ausgangsklemme 7a kann auch als Eingangsklemme zum Einstellen der Schwellwerte genutzt werden.

### Bezugszeichenliste

- 1.: Wandler, Sensor
- 2.: Verstärker
- 3.: Steuereinheit
- 4.: Analyseeinheit, Komparatoreinheit
- 5.: Ausgangsstufe
- 6.: Eingang
- 7a: Ausgang
- 7b: Ausgang
- 7c: Ausgang
- 7d: Ausgang

## Patentansprüche

1. Schaltungsanordnung mit einem einzigen Sensorelement (1) zum Umwandeln einer physikalischen Größe in ein elektrisches Signal, mit einer Komparatoreinheit (4), durch welche das elektrische Signal des Sensorelementes (1) mit verschiedenen unterschiedlichen Schwellwerten zur Erzeugung unterschiedlicher diskreter Schaltzustände verglichen wird, und mit einer Ausgabeeinheit (5) zur Ausgabe eines die unterschiedlichen diskreten Schaltzustände der Komparatoreinheit (4) darstellenden Ausgangssignales, wobei die Schwellwerte der Komparatoren der Komparatoreinheit (4) in einer Speichereinheit der Schaltungsanordnung über eine Steuereinrichtung (3) einstellbar gespeichert sind, wobei die Schwellwerte zu Schwellwertepaaren zusammengefasst sind, die beabstanden Wertintervalle festlegen, wobei jedem Wertintervall ein bestimmter diskreter Schaltzustand zugeordnet ist, und zwischen den einzelnen Wertintervallen eine Hysterese vorgesehen ist, wobei in der Komparatoreinheit (4) mehr als zwei unterschiedliche diskrete Schaltzustände erzeugt werden wobei die Schaltungsanordnung als integrierte Schaltungsanordnung ausgebildet ist und eine einzige Ausgangsklemme (7a) aufweist, an der ein Ausgangssignal abgreifbar ist, in dem die verschiedenen Schaltzustände des elektrischen Signals codiert sind.

2. Integrierte Schaltungsanordnung nach Anspruch 1 oder 2, **dadurch gekennzeichnet, daß** die Ausgangsklemme (7a) auch als Eingangsklemme für die Steuereinrichtung (3) dient.

3. Integrierte Schaltungsanordnung nach einem der Ansprüche 1 bis 2,
**dadurch gekennzeichnet, daß** die einstellbaren Schwellwerte vom Benutzer der Sensorschaltung einstellbar sind.

4. Integrierte Schaltungsänordnung nach einem der vorhergehenden Ansprüche,
**dadurch gekennzeichnet, daß** die Komparatoreinheit (4) so ausgebildet ist, daß kurzfristige Änderungen des Eingangssignals nicht zu einer Änderung des Schaltsignals führen.

## Claims

1. Circuitry having a single sensor element (1) for converting a physical quantity into an electrical signal, having a comparator unit (4) by which the electrical signal of the sensor element (1) is compared with various different threshold values to produce different discrete switching states, and having an output unit (5) for the output of an output signal representing the different discrete switching states of the comparator unit (4), wherein the threshold values of the comparators of the comparator unit (4) are adjustably stored in a memory unit of the circuitry via a control device (3), wherein the threshold values are combined to form pairs of threshold values which set spaced value intervals, wherein a determined discrete switching state is assigned to each value interval and a hysteresis is provided between the individual value intervals, wherein more than two different discrete switching states are generated in the comparator unit (4), wherein the circuitry is constructed as integrated circuitry and comprises a single output terminal (7a) at which an output signal can be tapped, in which the various switching states of the electrical signal are coded.

2. Integrated circuitry according to Claim 1 or 2,
**characterised in that** the output terminal (7a) also serves as the input terminal for the control device (3).

3. Integrated circuitry according to one of Claims 1 to 2,
**characterised in that** the adjustable threshold values can be adjusted by the user of the sensor circuit.

4. Integrated circuitry according to one of the preceding Claims,
**characterised in that** the comparator unit (4) is constructed so that the short-term changes in the input signal do not result in a change in the switching signal.

## Revendications

1. Circuit doté d'un unique élément capteur (1) pour convertir une grandeur physique en un signal électrique, dans lequel
- une unité de comparaison (4) reçoit le signal électrique de l'élément capteur (1) et le compare à diverses valeurs de seuil différentes pour créer des états de commutation discrets,
- une unité de sortie (5) délivre un signal de sortie représentant les différents états de commutation discrets de l'unité de compression (4),
- les valeurs de seuil des comparateurs de l'unité de comparaison (4) sont enregistrées dans une mémoire du circuit par l'intermédiaire d'une unité de commande (3),
- les valeurs de seuil sont réunies par paires de seuils définissant entre elles des intervalles, à chacun desquels est associé un état discret défini de commutation, avec une hystérésis entre les différents intervalles,
- dans l'unité de comparaison (4) sont créés plus de deux états de commutation discrets différents, et
- le circuit est un circuit intégré qui présente une seule borne de sortie (7a) sur laquelle peut être saisi le signal de sortie portant sous forme codée les différents états de commutation du signal électrique.

2. Circuit intégré selon la revendication 1,
**caractérisé en ce que**
la borne de sortie (7a) sert également de borne d'entrée pour l'unité de commande (3).

3. Circuit intégré selon la revendication 1 ou 2,
**caractérisé en ce que**
les valeurs de seuil peuvent être réglées par l'utilisateur du circuit.

4. Circuit intégré selon une des revendications 1 à 3,
**caractérisé en ce que**
l'unité de comparaison (4) est conçue de manière à éviter que des variations de courte durée du signal d'entrée conduisent à une modification du signal de commutation.
